# EUROPEAN PATENT APPLICATION

(11) **EP 2 048 702 A2**
(43) Date of publication of application: **15.04.2009**
(21) Application number: 08017200.0
(22) Date of filing: 30.09.2008
(51) Int. Cl.: H01L 21/306

(54) **Method for cleaning silicon wafer**

(30) Priority: 10.10.2007 KR 20070101900
(71) Applicant: Siltron Inc., Gumi-city, Gyeonsangbuk-Do 730-724 (KR)
(72) Inventor: Kim, In-Jung, Gyeongbuk 730-380 (KR); Bae, So-Ik, Daejeon, 302-841, (KR)
(74) Representative: Scheele, Friedrich

(57) **Abstract**

A method for cleaning a silicon wafer includes (S11) cleaning surfaces of a silicon wafer using an SC-1 cleaning solution according to standard clean 1; (S12) rinsing the surfaces of the silicon wafer, cleaned in the step S11, using deionized water; (S13) cleaning the surfaces of the silicon wafer, rinsed in the step S 12, using a cleaning solution including hydrochloric acid, ozone water and deionized water; (S 14) rinsing the surfaces of the silicon wafer, cleaned in the step S 13, using deionized water; and (S15) drying the surfaces of the silicon wafer, rinsed in the step S14. A stable oxide film is formed on the surfaces of the silicon wafer using a material having a strong oxidizing ability while a cleaning process is performed. Therefore, a problem that as time passes, external impurities are attached to the surfaces of the silicon wafer can be solved by a simple and safe process.

## Description

### TECHNICAL FIELD

The present invention relates to a method for cleaning a silicon wafer, and in particular, to a method for cleaning a silicon wafer, which cleans the surfaces of a silicon wafer using SC-1 cleaning solution according to standard clean 1 and rinses the silicon wafer surfaces, and then cleans the silicon wafer surfaces using a predetermined cleaning solution and rinses the silicon wafer surfaces in a repetitive manner to form a oxide film on the silicon wafer surfaces, thereby preventing haze contamination of the silicon wafer surfaces by a simply process.

### BACKGROUND

Surfaces of silicon wafers may be contaminated by various contaminants during a wafer fabricating process or a semiconductor process for device integration. In particular, after silicon wafers were stored in a cassette at a clean room and a predetermined time passed, or after packaged wafers were shipped, haze contamination may occur with time, which is referred to as time dependent haze (abbreviated to 'TDH'). It is known that a main material causing the haze contamination is a metal, environmental gas components or moisture. These contaminants result in the reduced yield of semiconductor devices. Therefore, when fabricating bare silicon wafers, a cleaning process is performed after a polishing processing using CMP (Chemical Mechanical Polishing) and when fabricating semiconductor devices, a cleaning process is performed after a unit semiconductor process generating much contaminants, so as to control the concentration of contaminants in wafers to a proper level.

RCA (Radio Corporation America) cleaning method is categorized as a wet cleaning technology, and is widely used so far. Other cleaning methods are suggested to solve drawbacks of the RCA cleaning method.

Typically, the RCA cleaning method performs a high-temperature wet process using chemicals of strong acids and strong bases having high concentration, and consists of two steps: standard clean 1 (called 'SC-1' for short) and standard clean 2 (called 'SC-2' for short).

The standard clean 1 (SC-1) is performed at temperature of about 75 to about 90°C using a mixed cleaning solution (hereinafter referred to as an 'SC-1 cleaning solution') of ammonia water, hydrogen peroxide and DI (deionized) water. The SC-1 performs oxidation of wafer surfaces by hydrogen peroxide and fine etching of wafer surfaces by ammonia water simultaneously and repeatedly to remove organic contaminants and metallic impurities (Au, Ag, Cu, Ni, Cd, Zn, Co or Cr) from the wafer surfaces. The standard clean 2 (SC-2) is performed at temperature of about 75 to about 85°C using a mixed cleaning solution (hereinafter referred to as an 'SC-2 cleaning solution') of hydrochloric acid, hydrogen peroxide and DI water. The SC-2 removes alkali ions (Al³⁺, Fe³⁺, Mg²⁺), hydroxides such as Al(OH)₃, Fe(OH)₃, Mg(OH)₂ or Zn(OH)₂ and remaining contaminants not removed in the SC-1.

Ions or organics existing on wafer surfaces or contaminants in the ambient environment, attached to wafer surfaces, make the wafer surfaces hydrophobic, and after the wafer is stored, haze contamination occurs with time. And, haze contamination occurs due to differences in temperature and humidity of atmosphere where wafers are located. As the differences are larger, haze contamination occurs more easily. Therefore, it is known that attachment of contaminants to the wafer surfaces can be prevented by making and keeping the wafer surfaces hydrophilic.

In other words, when the silicon wafer surfaces become hydrophilic, the silicon wafer surfaces are stabilized. When the silicon wafer surfaces are stabilized, the likelihood that various kinds of particles or impurities are attached to the silicon wafer surfaces before and after a cleaning process is minimized, thereby keeping the silicon wafer surfaces clear.

Studies have been made to explain various causes and route of time dependent haze. For example, Japan Patent Application No. 05-341168 suggests a technique to prevent the time dependent haze. According to the prior art, silicon wafers are processed by high temperature deionized water and isopropyl alcohol vapor, and then stored in an inactive atmosphere such as nitrogen or argon. However, this results in a complicated process, accidents caused by a high temperature process, and organic contamination and haze generation due to isopropyl alcohol.

As described above, if RCA cleaning method performed on silicon wafer surfaces and techniques suggested to solve drawbacks of the RCA cleaning method are used in combination, contaminants present on silicon wafer surfaces may be removed or surface roughness of silicon wafers may be improved. In this case, however, an excessive amount of cleaning solution is used, so that after a cleaning process, a dehydrogenation process should be performed to treat waste water, and consequently much costs are spent to treat waste water. Further, a cleaning process should be performed at high temperature, resulting in consumption of much energy, and uses a large amount of cleaning solution to increase process costs. In addition, a portion of metallic impurities removed by the cleaning process is attached to silicon wafers again and acts as contaminants.

Attempts have been continuously made in the related art to suggest an inventive method for cleaning a silicon wafer to prevent contamination that may occur to the surfaces of the silicon wafer before and after a cleaning process and haze contamination that may occur with time in the case of long-term storage, and the present invention was devised under such a technical environment.

### SUMMARY

The present invention is designed to prevent contamination that may occur to silicon wafers before and after a cleaning process, and haze contamination that may occur to the surfaces of silicon wafers with time in the case that the silicon wafers should be stored for a predetermined time. And, the present invention is designed to solve the problem of the prior art, i.e. a complicated and dangerous process. Therefore, it is an object of the present invention to provide a method of cleaning a silicon wafer, capable of fulfilling these technical aims.

To achieve the above-mentioned object, a method for cleaning a silicon wafer according to an embodiment of the present invention includes (S11) cleaning surfaces of a silicon wafer using an SC-1 cleaning solution according to standard clean 1; (S12) rinsing the surfaces of the silicon wafer cleaned in the step S11 using deionized water; (S 13) cleaning the surfaces of the silicon wafer rinsed in the step S12 using a cleaning solution including hydrochloric acid, ozone water and deionized water; (S 14) rinsing the surfaces of the silicon wafer cleaned in the step S13 using deionized water; and (S 15) drying the surfaces of the silicon wafer rinsed in the step S 14.

Preferably, the step S 13 is performed while applying ultrasonic vibration to the cleaning solution. The SC-1 cleaning solution according to standard clean 1 in the step S11 includes ammonium hydroxide, hydrogen peroxide and deionized water. Preferably, the ammonium hydroxide is included with a concentration between 2 and 20% based on weight of the deionized water, and the hydrogen peroxide is included with a concentration between 4 and 20% based on weight of the deionized water. Preferably, the cleaning step of S 11 is performed at temperature between 50 and 80°C during 3 to 10 minutes. In the cleaning solution of S13, the hydrochloric acid is preferably included with a concentration between 1 and 10% based on weight of the deionized water. Preferably, the cleaning step of S 13 is performed at temperature between 20 and 30°C during 3 to 10 minutes. Preferably, ozone included in the cleaning solution of S 13 has a concentration between 1 and 20 ppm based on the deionized water.

A method for cleaning a silicon wafer according to another embodiment of the present invention includes (S21) cleaning surfaces of a silicon wafer using an SC-1 cleaning solution according to standard clean 1; (S22) rinsing the surfaces of the silicon wafer cleaned in the step S21 using deionized water; (S23) cleaning the surfaces of the silicon wafer rinsed in the step S22 using an SC-2 cleaning solution according to standard clean 2; (S24) rinsing the surfaces of the silicon wafer cleaned in the step S23 using deionized water; (S25) cleaning the surfaces of the silicon wafer rinsed in the step S24 using ozone water; (S26) rinsing the surfaces of the silicon wafer cleaned in the step S25 using deionized water; and (S27) drying the surfaces of the silicon wafer rinsed in the step S26.

The SC-1 cleaning solution according to standard clean 1 in the step S21 includes ammonium hydroxide, hydrogen peroxide and deionized water. Preferably, the ammonium hydroxide is included with a concentration between 2 and 20% based on weight of the deionized water, and the hydrogen peroxide is included with a concentration between 4 and 20% based on weight of the deionized water. Preferably, the cleaning step of S21 is performed at temperature between 50 and 80°C during 3 to 10 minutes. The SC-2 cleaning solution according to standard clean 2 in the step S23 includes hydrochloric acid, hydrogen peroxide and deionized water. Preferably, the hydrochloric acid is included with a concentration between 10 and 40% based on weight of the deionized water, and the hydrogen peroxide is included with a concentration between 10 and 40% based on weight of the deionized water. Preferably, the cleaning step of S23 is performed at temperature between 50 and 80°C during 3 to 10 minutes.

### BRIEF DESCRIPTION OF THE DRAWINGS

Hereinafter, preferred embodiments of the present invention will be described in detail with reference to the accompanying drawings. Prior to the description, it should be understood that the terms used in the specification and the appended claims should not be construed as limited to general and dictionary meanings, but interpreted based on the meanings and concepts corresponding to technical aspects of the present invention on the basis of the principle that the inventor is allowed to define terms appropriately for the best explanation.
FIG. 1 is a flow chart illustrating a method for cleaning a silicon wafer according to an embodiment of the present invention.
FIG. 2 is a flow chart illustrating a method for cleaning a silicon wafer according to another embodiment of the present invention.
FIG. 3 illustrates photographs showing haze generated to silicon wafers of examples 1 and 2 according to the present invention and a comparative example.
FIG. 4 is an XPS (X-ray Photoelectron Spectroscopy) analysis graph illustrating chemical bonds on the surfaces of the silicon wafers of the example 2 and the comparative example.

### DETAILED DESCRIPTION

Hereinafter, preferred embodiments of the present invention will be described in detail with reference to the accompanying drawings. Prior to the description, it should be understood that the terms used in the specification and the appended claims should not be construed as limited to general and dictionary meanings, but interpreted based on the meanings and concepts corresponding to technical aspects of the present invention on the basis of the principle that the inventor is allowed to define terms appropriately for the best explanation.

### Example 1

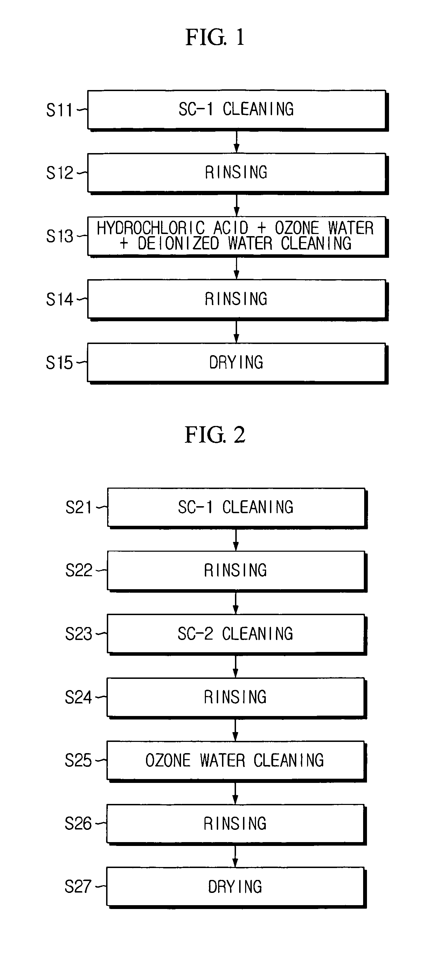

A method for cleaning a silicon wafer according to an embodiment of the present invention performs steps S11 to S 15 in sequence, and is described with reference to FIG. 1.

FIG. 1 is a flow chart illustrating a method for cleaning a silicon wafer according to an embodiment of the present invention.

First, the surfaces of a silicon wafer are cleaned using an SC-1 cleaning solution according to standard clean 1 (S11). The SC-1 cleaning solution according to standard clean 1 in the step S 11 includes ammonium hydroxide, hydrogen peroxide and deionized water. Preferably, the ammonium hydroxide is included with a concentration between 2 and 20% based on weight of the deionized water, and the hydrogen peroxide is included with a concentration between 4 and 20% based on weight of the deionized water. Preferably, the cleaning step of S11 is performed at temperature between 50 and 80°C during 3 to 10 minutes. In this embodiment, a weight ratio between ammonium hydroxide, hydrogen peroxide and deionized water is adjusted to 1:1:5, and the cleaning step of S11 is performed at temperature of 60°C during 5 minutes. The SC-1 cleaning solution is alkalic and corrosive, and removes particles and organics very well.

The surfaces of the silicon wafer cleaned in the step S 11 are rinsed using deionized water (S12).

The surfaces of the silicon wafer rinsed in the step S12 are cleaned using a cleaning solution including hydrochloric acid, ozone water and deionized water (S 13). In the cleaning solution of S 13, the hydrochloric acid is preferably included with a concentration between 1 and 10% based on weight of the deionized water. Preferably, the cleaning step of S 13 is performed at temperature between 20 and 30°C during 3 to 10 minutes. Preferably, ozone included in the cleaning solution of S 13 has a concentration between 1 and 20 ppm based on the deionized water. The cleaning step of S 13 can remove metals attached to the silicon wafer, and form a oxide film of good hydrophilic property due to ozone. In this embodiment, a weight ratio between hydrochloric acid and deionized water is adjusted to 1:50, and the cleaning step of S13 is performed at 20°C during 5 minutes. Through the cleaning step of S 13, a stable oxide film is formed on the surfaces of the silicon wafer to prevent attachment of external contaminants and generation of time dependent haze. At this time, preferably ultrasonic vibration is applied to the cleaning solution in the step S13, which improves a cleaning performance. The oxide film formed on the surfaces of the silicon wafer is caused by the ozone water, and ozone having concentration of 2 ppm was used. In the case that the concentration of ozone is less than the above-mentioned minimum, it is not preferred because an ability to form an oxide film is insufficient, and consequently particles may be attached to the surfaces of the silicon wafer or a watermark may be created in a subsequent drying process, thereby resulting in deterioration of the surfaces of silicon wafer. In the case that the concentration of ozone is in the above-mentioned range, it is preferred because the oxide film is uniformly formed on the surfaces of silicon wafer, the oxide film makes the silicon wafer surfaces hydrophilic, and perfect bonds having less oxygen vacancies or hydrogen bonds are formed on the surfaces of the silicon wafer.

The surfaces of the silicon wafer cleaned in the step S 13 are rinsed using deionized water (S 14). Finally, the surfaces of the silicon wafer rinsed in the step S 14 are dried (S15).

### Example 2

A method for cleaning a silicon wafer according to another embodiment of the present invention performs steps S21 to S27 in sequence, and is described with reference to FIG. 2.

FIG. 2 is a flow chart illustrating a method for cleaning a silicon wafer according to another embodiment of the present invention.

The surfaces of a silicon wafer are cleaned using an SC-1 cleaning solution according to standard clean 1 (S21).

The SC-1 cleaning solution according to standard clean 1 in the step S21 includes ammonium hydroxide, hydrogen peroxide and deionized water. Preferably, the ammonium hydroxide is included with a concentration between 2 and 20% based on weight of the deionized water, and the hydrogen peroxide is included with a concentration between 4 and 20% based on weight of the deionized water. Preferably, the cleaning step of S21 is performed at temperature between 50 and 80°C during 3 to 10 minutes. The cleaning step of S21 is similar to that of the example 1, and its description is omitted.

The surfaces of the silicon wafer cleaned in the step S21 are rinsed using deionized water (S22).

The surfaces of the silicon wafer rinsed in the step S22 are cleaned using an SC-2 cleaning solution according to standard clean 2 (S23). The SC-2 cleaning solution according to standard clean 2 in the step S23 includes hydrochloric acid, hydrogen peroxide and deionized water. Preferably, the hydrochloric acid is included with a concentration between 10 and 40% based on weight of the deionized water, and the hydrogen peroxide is included with a concentration between 10 and 40% based on weight of the deionized water. Preferably, the cleaning step of S23 is performed at temperature between 50 and 80°C during 3 to 10 minutes. The cleaning step of S23 forms a chloride, and consequently removes metallic contaminants deposited on the surfaces of the silicon wafer. In this embodiment, the concentration of hydrochloric acid is adjusted to 37%, the concentration of hydrogen peroxide is adjusted to 31%, and the cleaning step of S23 is performed at temperature of 60°C during 5 minutes.

The surfaces of the silicon wafer cleaned in the step S23 are rinsed using deionized water (S24).

The surfaces of the silicon wafer rinsed in the step S24 are cleaned using ozone water (S25). Preferably, the cleaning step of S25 is performed by soaking the silicon wafer into a chemical tank containing ozone water including ozone and deionized water.

The surfaces of the silicon wafer cleaned in the step S25 are rinsed using deionized water (S26). Finally, the surfaces of the silicon wafer rinsed in the step S26 are dried (S27).

### Comparative example

A silicon wafer is cleaned by a typical RCA cleaning method. That is, the silicon wafer is cleaned using an SC-1 cleaning solution and an SC-2 cleaning solution in sequence.

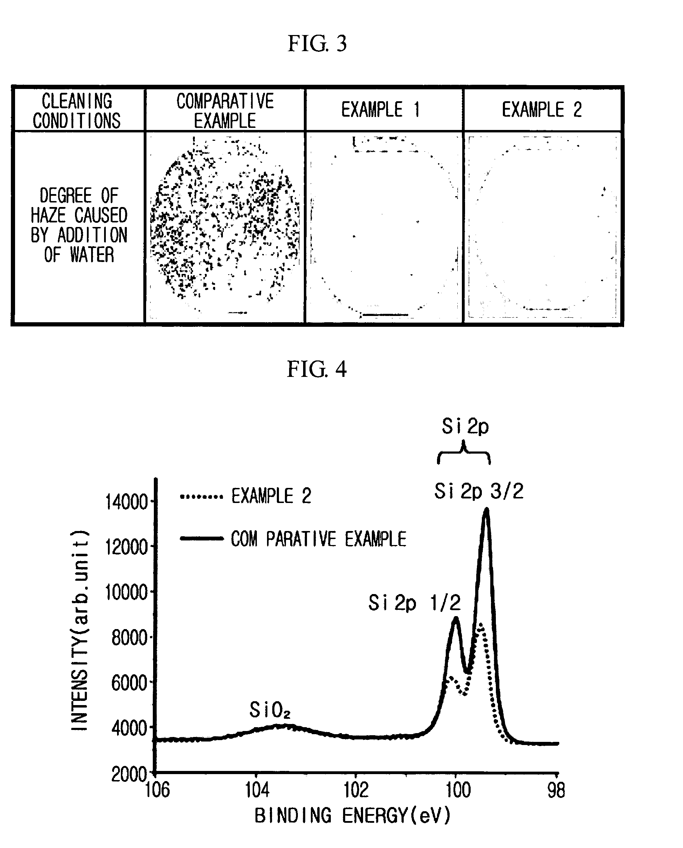

FIG. 3 illustrates photographs showing haze generated to silicon wafers of examples 1 and 2 according to the present invention and a comparative example.

Silicon wafers cleaned according to the comparative example and the examples 1 and 2 were arranged at the center of a box in a staggered manner, and 0.5Mℓ of moisture was added. The box was closed, completely sealed and placed in a clean room during 36 hours, and the degree of haze was detected with LLS (Localized Light Scatterer). As shown in FIG 3, it was found that particles of 0.12µm or more were attached to the silicon wafer of the comparative example, and haze occurred to the silicon wafers of the examples 1 and 2 relatively less than the comparative example.

FIG. 4 is an XPS analysis graph that explains evaluation of a difference in bond density of silicon and oxygen between oxide films formed according to the example 2 and the comparative example through XPS analysis, and illustrates chemical bonds on the surfaces of the silicon wafers of the example 2 and the comparative example. The peaks of binding energy of Si-Si and Si-O in the comparative example and the example 2 were observed at the same location on the X-axis of the graph.

Referring to FIG. 4, the silicon wafer of the example 2 has an oxide film formed by an ozone process and the silicon wafer of the comparative example has an oxide film that is not formed by an ozone process. The Si-Si peak and Si-O peak of each oxide film were observed. The intensity of Si-Si peak of the example 2 was relatively lower than that of the comparative example, but there was not too large difference in intensity of Si-O peak therebetween. Meanwhile, the bond strength of SiO2 in an oxide film can be inferred though an area ratio of area at Si-O peak to area at Si-Si peak. As shown in FIG. 4, an area ratio of the example 2 was higher than that of the comparative example. Therefore, it was found that the silicon wafer of the example 2 had a higher bond strength of SiO2 in an oxide film than that of the comparative example.

According to the results, it was analyzed that haze occurred to the comparative example to make the surface of the oxide film unstable, or that after an RCA cleaning process, an edge portion of the oxide film became unstable as time passed, which generated haze. Therefore, it was found that the oxide film formed by an ozone process according to the present invention had a high stability and prevented re-attachment of contaminant particles. The oxide film served as a protective film of the surfaces of the silicon wafer to prevent impurities from attaching to the surfaces of the silicon wafer, thereby providing a silicon wafer having high quality surfaces.

As such, the present invention forms a stable oxide film on the surfaces of a silicon wafer using a material having a strong oxidizing ability while a cleaning process is performed. Therefore, a problem that as time passes, external impurities are attached to the surfaces of the silicon wafer can be solved by a simple and safe process.

It should be understood that the detailed description and specific examples, while indicating preferred embodiments of the invention, are given by way of illustration only, since various changes and modifications within the spirit and scope of the invention will become apparent to those skilled in the art from this detailed description.

## Claims

1. A method for cleaning a silicon wafer, comprising:
(S11) cleaning surfaces of a silicon wafer using an SC-1 cleaning solution according to standard clean 1;
(S12) rinsing the surfaces of the silicon wafer cleaned in the step S11 using deionized water;
(S13) cleaning the surfaces of the silicon wafer rinsed in the step S 12 using a cleaning solution including hydrochloric acid, ozone water and deionized water;
(S 14) rinsing the surfaces of the silicon wafer cleaned in the step S 13 using deionized water; and
(S 15) drying the surfaces of the silicon wafer rinsed in the step S 14.

2. The method for cleaning a silicon wafer according to claim 1,
wherein the step S13 is performed while applying ultrasonic vibration to the cleaning solution.

3. The method for cleaning a silicon wafer according to claim 1 or 2,
wherein the SC-1 cleaning solution according to standard clean 1 in the step S11 includes ammonium hydroxide, hydrogen peroxide and deionized water,
wherein the ammonium hydroxide is included with a concentration between 2 and 20% based on weight of the deionized water, and
wherein the hydrogen peroxide is included with a concentration between 4 and 20% based on weight of the deionized water.

4. The method for cleaning a silicon wafer according to claim 1 or 2,
wherein the cleaning step of S11 is performed at temperature between 50 and 80°C during 3 to 10 minutes.

5. The method for cleaning a silicon wafer according to claim 1 or 2,
wherein, in the cleaning solution of S13, the hydrochloric acid is included with a concentration between 1 and 10% based on weight of the deionized water.

6. The method for cleaning a silicon wafer according to claim 1 or 2,
wherein the cleaning step of S13 is performed at temperature between 20 and 30°C during 3 to 10 minutes.

7. The method for cleaning a silicon wafer according to claim 1 or 2,
wherein ozone included in the cleaning solution of S13 has a concentration between 1 and 20 ppm based on the deionized water.

8. A method for cleaning a silicon wafer, comprising:
(S21) cleaning surfaces of a silicon wafer using an SC-1 cleaning solution according to standard clean 1;
(S22) rinsing the surfaces of the silicon wafer cleaned in the step S21 using deionized water;
(S23) cleaning the surfaces of the silicon wafer rinsed in the step S22 using an SC-2 cleaning solution according to standard clean 2;
(S24) rinsing the surfaces of the silicon wafer cleaned in the step S23 using deionized water;
(S25) cleaning the surfaces of the silicon wafer rinsed in the step S24 using ozone water;
(S26) rinsing the surfaces of the silicon wafer cleaned in the step S25 using deionized water; and
(S27) drying the surfaces of the silicon wafer rinsed in the step S26.

9. The method for cleaning a silicon wafer according to claim 8,
wherein the SC-1 cleaning solution according to standard clean 1 in the step S21 includes ammonium hydroxide, hydrogen peroxide and deionized water,
wherein the ammonium hydroxide is included with a concentration between 2 and 20% based on weight of the deionized water, and
wherein the hydrogen peroxide is included with a concentration between 4 and 20% based on weight of the deionized water.

10. The method for cleaning a silicon wafer according to claim 8,
wherein the cleaning step of S21 is performed at temperature between 50 and 80°C during 3 to 10 minutes.

11. The method for cleaning a silicon wafer according to claim 8,
wherein the SC-2 cleaning solution according to standard clean 2 in the step S23 includes hydrochloric acid, hydrogen peroxide and deionized water,
wherein the hydrochloric acid is included with a concentration between 10 and 40% based on weight of the deionized water, and
wherein the hydrogen peroxide is included with a concentration between 10 and 40% based on weight of the deionized water.

12. The method for cleaning a silicon wafer according to claim 8,
wherein the cleaning step of S23 is performed at temperature between 50 and 80°C during 3 to 10 minutes.
